**Europäisches Patentamt**

**European Patent Office**

**Office européen des brevets**

(11) Veröffentlichungsnummer: **0 512 245 A1**

# EUROPÄISCHE PATENTANMELDUNG

(21) Anmeldenummer: **92105499.5**

(51) Int. Cl.5: **H03J 1/00**, H04H 1/00

(22) Anmeldetag: **31.03.92**

(30) Priorität: **06.05.91 DE 4114719**

(43) Veröffentlichungstag der Anmeldung:
**11.11.92 Patentblatt 92/46**

(84) Benannte Vertragsstaaten:
**CH DE FR GB LI**

(71) Anmelder: **GRUNDIG E.M.V.**
**Elektro-Mechanische Versuchsanstalt Max**
**Grundig holländ. Stiftung & Co. KG.**
**Kurgartenstrasse 37**
**W-8510 Fürth/Bay.(DE)**

(72) Erfinder: **Rosenberger, Winfried, c/o**
**GRUNDIG E.M.V.**
**holländ. Stiftung & Co. KG, Kurgartenstrasse**
**37**
**W-8510 Fuerth(DE)**

(74) Vertreter: **Eichstädt, Alfred**
**Grundig E.M.V. Elektro-Mechanische**
**Versuchsanstalt Kurgartenstrasse 37**
**W-8510 Fürth(DE)**

(54) **Vorrichtung zur wahlfreien Belegung der Programmplätze eines Empfängers für digitale Satelliten-Hörrundfunksignale.**

(57) Die Erfindung betrifft eine Vorrichtung zur wahlfreien Belegung der Programmplätze eines Empfängers für digitale Satelliten-Hörrundfunksignale, welche blockweise in einem oder mehreren Fernsehkanälen übertragen werden. Die beanspruchte Vorrichtung weist einen programmierbaren Speicher mit mehreren Speicherbereichen auf, von denen jeder einem Programmplatz zugeordnet ist und zur Abspeicherung von Informationen über den Frequenzbereich eines ausgewählten Blockes und den ausgewählten Kanal innerhalb des ausgewählten Blockes dimensioniert ist.

Die Erfindung betrifft eine Vorrichtung zur wahlfreien Belegung der Programmplätze eines Empfängers für digitale Satelliten-Hörrundfunksignale mit den im Oberbegriff des Anspruchs 1 angegebenen Merkmalen.

Aus dem vom Bundesministerium für Post und Telekommunikation herausgegebenen Informationsheft "Der Digitale Hörfunk" ist es bereits bekannt, einen Fernsehkanal eines Rundfunksatelliten zur Übertragung eines Blocks von 16 digitalen Hörrundfunkprogrammen zu verwenden. Dazu werden die in den Programmstudios der Rundfunkanstalten Produzierten Signale digital zu einer Sendeerdfunkstelle der Deutschen Bundespost übermittelt. Dort werden alle 16 Kanäle mittels eines Zeitmultiplexverfahrens zusammengefaßt und für die Übertragung über die Satellitenstrecke neu codiert. Bei dieser Codierung werden die Signale in zwei Hauptrahmen A und B eingesetzt, wobei die Programme 1 bis 8 im Hauptrahmen A und die Programme 9 bis 16 im Hauptrahmen B liegen. Über eine Hochleistungsantenne werden die Signale zum Satelliten gesendet. In einem Satellitentransponder wird das Signal verstärkt, umgesetzt und über eine scharf bündelnde Antenne wieder zur Erde zurückgesendet. Dort können die Signale entweder direkt oder über das Breitbandverteilnetz der Deutschen Bundespost empfangen werden.

Aus der Zeitschrift "Funkschau", Heft 2, 1990, S. 51-53, ist es bereits bekannt, den genannten Block von 16 digitalen Hörrundfunkprogrammen in den Sonderkanälen zwei und drei des Breitbandverteilnetzes bzw. Kabelnetzes der Deutschen Bundespost zum Endkunden zu übertragen, was dem Frequenzbereich von 111 bis 125 MHz bzw. 118 MHz ± 7 MHz entspricht. Innerhalb des genannten Blocks sind die einzelnen Hörfunkprogramme den Hörrundfunkkanälen 1-16 fest zugeordnet. Ein beim Endkunden angeordneter Empfänger für die digitalen Rundfunksignale weist 16 Stationstasten auf, mittels der die einzelnen Hörfunkkanäle angewählt werden können.

Werden zukünftig auf anderen Satellitentranspondern desselben oder eines anderen Satelliten weitere Blöcke von jeweils 16 digitalen Hörrundfunkprogrammen übertragen, dann müßten weitere Kanäle bzw. Frequenzbereiche des Breitbandverteilnetzes der Deutschen Bundespost zur Verfügung gestellt werden, um diese Programme zum Endkunden weiterleiten zu können. Der beim Endkunden angeordnete Empfänger benötigt in diesem Fall eine Umschaltmöglichkeit zur Anwahl des gewünschten anderen Blockes. Nach der genannten Umschaltung auf den gewünschten anderen Block kann dann mittels einer der 16 Stationstasten des Empfängers jedes der in diesem Block übertragenen Hörrundfunkprogramme angewählt werden. Dieses Umschalten zwischen verschiedenen Blöcken ist jedoch umständlich.

Ausgehend von diesem Stand der Technik liegt der Erfindung die Aufgabe zugrunde, einen Weg aufzuzeigen, wie bei einer Vorrichtung mit den im Oberbegriff des Anspruchs 1 angegebenen Merkmalen die Anwahl gewünschter Hörrundfunkprogramme vereinfacht werden kann.

Diese Aufgabe wird bei einer Vorrichtung mit den im Oberbegriff des Anspruchs 1 angegebenen Merkmalen durch die im kennzeichnenden Teil des Anspruchs 1 angegebenen Merkmale gelöst. Eine vorteilhafte Weiterbildung ergibt sich aus dem Unteranspruch.

Die Vorteile der Erfindung bestehen insbesondere darin, daß der Endkunde die Programmplätze seines Empfängers für digitale Satelliten-Hörrundfunksignale frei belegen kann, so daß er bei der Anwahl von Hörrundfunkprogrammen, die in unterschiedlichen Blöcken bzw. über unterschiedliche Satelliten-Transponder eines oder mehrerer Satelliten übertragen werden, nicht zwischen den einzelnen Blöcken umschalten muß.

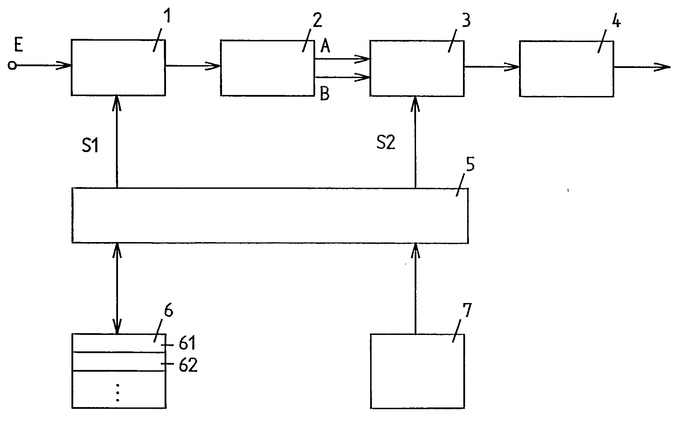

Weitere Eigenschaften und Vorteile der Erfindung ergeben sich aus der Erläuterung eines Ausführungsbeispiels anhand der Figur.

Die Figur zeigt die zum Verständnis der Erfindung wesentlichen Bauteile eines Empfängers für digitale Satelliten-Hörrundfunksignale.

Der Eingang E der gezeigten Vorrichtung ist an das Kabelnetz der Deutschen Bundespost angeschlossen, in welchem in mehreren Fernsehkanälen, deren Frequenzen im Bereich zwischen 50 und 855 MHz liegen, Blöcke von jeweils 16 digitalen Hörrundfunkprogrammen übertragen werden. Der Signalaufbau dieser Hörrundfunkprogramme ist ausführlich beschrieben in der Informationsbroschüre des Bundesministers für Forschung und Technologie "Digitaler Hörfunk über Rundfunksatelliten", auf die hiermit Bezug genommen wird.

Zur Erläuterung der Erfindung wird angenommen, daß ein erster Block mit 16 digitalen Hörrundfunkprogrammen in einem ersten Fernsehkanal im Frequenzbereich x, ein zweiter Block mit ebenfalls 16 digitalen Hörrundfunkprogrammen in einem zweiten Fernsehkanal im Frequenzbereich y und ein dritter Block mit 16 digitalen Hörrundfunkprogrammen in einem dritten Fernsehkanal im Frequenzbereich z übertragen werden.

Das am Eingang anliegende Signal wird einem Frequenzumsetzer 1 zugeführt. Dieser besteht im gezeigten Ausführungsbeispiel aus einer Kabeltuner/Konvertereinheit, in welcher eines der Eingangssignale, welches im Frequenzbereich x, y oder z vorliegt, selektiert und in einen niedrigeren, für alle Eingangssignalfrequenzen gleichen Frequenzbereich umgesetzt wird, welcher beispielsweise bei 118 MHz liegt.

Der Kabeltuner/Konvertereinheit wird ein von einem Mikrocomputer 5 erzeugtes Steuersignal S1 zugeführt, welches Informationen über das zur Frequenzumsetzung nötige Teilerverhältnis eines im Frequenzumsetzer angeordneten Teilers enthält.

Das Ausgangssignal des Frequenzumsetzers 1 wird in einem Demodulator 2 demoduliert. Bei diesem Demodulator handelt es sich um einen 4 PSK-Demodulator, welcher an seinem Ausgang A die im Hauptrahmen A übertragenen Programme 1 bis 8 und an seinem Ausgang B die im Hauptrahmen B übertragenen Programme 9 bis 16 zur Verfügung stellt.

Diese Signale werden einem Decoder 3 zugeführt, in welchem eine Auswahl eines der 16 Programme und eine Decodierung desselben erfolgt. Zur Auswahl des gewünschten Programmes wird dem Decoder 3 vom Mikrocomputer 5 ein Steuersignal S2 zugeführt, welches Informationen über die Nummer des Kanals enthält, in welchem das gewünschte Hörrundfunkprogramm innerhalb des ausgewählten Fernsehkanals übertragen wird. Das am Ausgang des Decoders 3 erhaltene digitale Signal wird in einem D/A-Wandler 4 in ein analoges Signal umgewandelt und kann von dort aus herkömmlichen Audiogeräten zur Wiedergabe und/oder Aufzeichnung zugeführt werden.

Im folgenden wird beschrieben, wie die Belegung der Programmplätze bei der gezeigten Vorrichtung erfolgt.

Mittels der Bedientastatur 7 wird ein Programmplatz angewählt, beispielsweise der Programmplatz 1. Anschließend wird ebenfalls mittels der Bedientastatur der Block, in welchem das Hörrundfunkprogramm übertragen wird, welches auf den Programmplatz 1 gelegt werden soll, angewählt. Der Mikrocomputer 5 erzeugt in Ansprache auf diese Blockanwahl ein Steuersignal S1, welches eine Information über ein Teilerverhältnis enthält. Dieses Teilerverhältnis wird im Frequenzumsetzer 1 zur Auswahl des gewünschten Fernsehkanals und zur Umsetzung des in diesem Kanal übertragenen Hörrundfunkprogrammblockes in den oben genannten niedrigeren Frequenzbereich verwendet. Danach wird mittels der Bedientastatur 7 der Kanal, in welchem das gewünschte Hörrundfunkprogramm innerhalb des ausgewählten Blockes übertragen wird, angewählt. Der Mikrocomputer 5 erzeugt in Ansprache auf diese Kanalwahl ein Steuersignal S2, welches dem Decoder 3 zur Auswahl und Decodierung des gewünschten Hörrundfunkprogramms zugeführt wird.

Durch Betätigung einer Speichertaste der Bedientastatur 7 werden in einem dem Programmplatz 1 zugeordneten Speicherbereich 61 des Speichers 6 sowohl das Steuersignal S1 als auch das Steuersignal S2 abgespeichert.

Ebenso erfolgt die Abspeicherung weiterer Steuersignale S1 und S2 für weitere vom Benutzer gewünschte Hörrundfunkprogramme in weiteren Speicherbereichen 62, ..., des Speichers 6, wobei jeder Speicherbereich einem Programmplatz zugeordnet ist.

Wird im späteren Gerätebetrieb ein Programmplatz angewählt, dann liest der Mikrocomputer 5 aus dem zugehörigen Speicherbereich des Speichers 6 die diesem Programmplatz und damit dem gewünschten Hörrundfunkprogramm zugehörigen Informationen für den Frequenzumsetzer 1 und den Decoder 3 aus und sorgt auf diese Weise automatisch dafür, daß das gewünschte Hörrundfunkprogramm ausgewählt, frequenzumgesetzt, demoduliert und decodiert wird. Eine Umschaltung des Blockes seitens des Benutzers ist folglich nicht notwendig.

**Patentansprüche**

1. Vorrichtung zur wahlfreien Belegung der Programmplätze eines Empfängers für digitale Satelliten-Hörrundfunksignale, welche blockweise in einem oder mehreren Fernsehkanälen übertragen werden, mit
   - einem Frequenzumsetzer zur Herabsetzung der Frequenz eines ausgewählten Blockes von Hörrundfunksignalen von einem ersten in einen zweiten, niedrigeren Frequenzbereich,
   - einem Demodulator für die in den niedrigeren Frequenzbereich umgesetzten Hörrundfunksignale, und
   - einem Decoder zur Auswahl und Decodierung eines der in einem ausgewählten Kanal des ausgewählten Blockes enthaltenen Hörrundfunksignale,

   **dadurch gekennzeichnet,** daß sie einen programmierbaren Speicher (6) mit mehreren Speicherbereichen (61, 62, ...) aufweist, von denen jeder einem Programmplatz zugeordnet ist und zur Abspeicherung von Informationen über den Frequenzbereich des ausgewählten Blockes und den ausgewählten Kanal innerhalb des ausgewählten Blockes dimensioniert ist.

2. Vorrichtung nach Anspruch 1
   **dadurch gekennzeichnet,** daß sie einen Mikrocomputer (5) aufweist, welcher bei Auswahl eines Kanals die diesem Kanal zugehörigen Informationen aus dem jeweiligen Speicherbereich (61, 62, ...) ausliest und dem Frequenzumsetzer (1) ein erstes Steuersignal (S1) zur Anwahl des dem ausgewählten Kanal zugeordneten Blockes und dem Decoder (3) ein zweites Steuersignal (S2) zur Anwahl des Kanals zuführt.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 285 869 (BRIONVEGA S.P.A.) <br> * Spalte 5, Zeile 17 - Spalte 6, Zeile 49 * <br> --- | 1,2 | H03J1/00 <br> H04H1/00 |
| Y | Ergänzende Bedienungshinweise: Telefunken DSR-Tuner ST 900 SAT. <br> * das ganze Dokument * <br> --- | 1,2 | |
| A | IEEE 1989 International Conference on Consumer Electronics, pages 86-87, New York, USA. Klank and Rottman: "DSR-Receiver for the Digital Sound Broadcasting via European Satellites TV-SAT/TDF. <br> * das ganze Dokument * <br> ----- | 1,2 | |
| | | | **RECHERCHIERTE SACHGEBIETE (Int. Cl.5)** <br><br> H03J <br> H04H |

Der vorliegende Recherchenbericht wurde für alle Patentansprüche erstellt

| Recherchenort | Abschlußdatum der Recherche | Prüfer |
|---|---|---|
| DEN HAAG | 10 AUGUST 1992 | PEETERS M.M.G. |